# EUROPEAN PATENT APPLICATION

(11) **EP 4 561 269 A1**
(43) Date of publication of application: **28.05.2025**
(21) Application number: 23383190.8
(22) Date of filing: 22.11.2023
(51) Int. Cl.: H05K 1/02, H05K 3/00, H05K 3/12, H05K 3/28, B29C 45/14

(54) **METHOD FOR MANUFACTURING TRIM PANELS FOR VEHICLES HAVING AN ELECTRONIC FUNCTION**

(71) Applicant: Grupo Antolin-Ingenieria, S.A., 09007 Burgos (ES)
(72) Inventor: CASTILLO GARCÍA, Marta, 09007 Burgos (ES); UBIERNA MARTÍNEZ, Lucio, 09007 Burgos (ES); ANTÓN LARA, Araceli, 09007 Burgos (ES)
(74) Representative: Capitán García, Maria Nuria

(57) **Abstract**

Method for manufacturing trim panels for vehicles having an electronic function comprising the steps of providing a first sheet 1 comprising a flexible flat plastic film having a first area being flat; a first printing step by a two-dimensional printing process for configuring an electrical conductive track on the first sheet; forming the first sheet according to a three-dimensional shape in such a way that the first area has a three-dimensional shape; a second printing step by fluid dispensing or pad printing for configuring an electrical conductive pad with a conductive ink 7 on the first area; attaching an electronic component 3 to the electrical conductive pad; injecting a plastic material on the first sheet 1 forming a carrier sheet 4; and providing a decorative covering 5 on the carrier sheet 4 comprising a pictogram configured for cooperating with the electronic component 3.

## Description

### TECHNICAL FIELD OF THE INVENTION

The present invention relates to a method for manufacturing trim panels for vehicles having an electronic function by In-Mold electronics (IME) technology.

### BACKGROUND OF THE INVENTION

In order to increase the comfort of the vehicle occupants is common to add electronic functions to the already existing trim panels such as a lighting function being decorative or functional and/or a switching function for controlling vehicle functions such as the air conditioning system or the like.

In some cases, both functions are jointly provided in such a way that the lighting function informs the vehicle occupant on the possibilities of interaction with the different switching areas concealed inside the trim panel.

One of the current trends to save cost, space, weight and to simplify the methods and the installations for manufacturing these functional trim panels, is to provide integral parts manufactured by In-Mold Electronics (IME) technology.

The main idea of this technology is to integrate electronics into plastics. To do this, electrical conductive inks are printed on plastic films for configuring electrical circuits where electronic components are mounted. In addition, said plastic film can be formed and trimmed to match the geometry of the final molded trim part. Then, the film is introduced inside a plastic injection mold and then over-molded encapsulating all circuitry and electronic components with the plastic material injected. Said plastic material in addition to protect all the electronic components, acts as a structural carrier for the trim part.

Additionally, and in order to complete the trim panel, the structural carrier comprises a decorative covering on the opposite side regarding the functional film.

Said decorative covering forms the external surface of the trim panel concealing the circuitry and the electronic components and at the same time can act as an interacting surface for the vehicle occupant since that all the components are concealed, or merely as a visible surface showing a particular decorative effect.

For this, the decorative covering commonly comprises pictograms used for communication purposes, which the vehicle occupant can identify or for decorative purposes defining a particular light effect.

In case pictograms are used for communication purposes they provide information about some function of the vehicle such as the indication of the position of a switching area being concealed by the decorative covering or the state of some component of the vehicle as the unlock state of the airbag.

For that, said pictograms can comprise a light transmitting portion being backlighted in order to make easier their identification and in order to provide additional information by changing the colour and/or the intensity of the light according to the particular circumstance, or they also can comprise an opaque portion representing a distinguishing portion in the decorative covering due to a change of color, a change of relief or both.

In case pictograms are used for decorative purposes they can comprise a light transmitting portion being backlighted in order to show a particular decorative light effect.

Taking into account that the electronic components, namely the lighting devices, sensors, etc. are provided in a plastic film being at one side of structural carrier forming the trim part, and the pictograms are provided in the decorative covering being at the opposite side thereof, it is very important that each particular electronic component are conveniently positioned regarding the corresponding pictogram with which it cooperates.

The term cooperation in the context of the invention means that the electronic component and the pictogram work together for a common purpose such as a lighting purpose or a switching purpose.

Some problems can arise if the position of the particular electronic component regarding the pictogram with which it cooperates is not ensured.

For example, in case the electronic component is a lighting device such as a LED, if it is not convenient positioned regarding the pictogram undesirable hot spot can be seen through the pictogram or the lighting emitted through said pictogram can have insufficient intensity.

In case the electronic component is a sensing antenna for a proximity switch sensor, if it is not correctly aligned with the pictogram a reduction of the sensibility or even the malfunction of the switching function can occur.

Therefore, one of the major challenges of this technology is to ensure the accuracy of the position of each electronic component regarding the corresponding pictogram with which it cooperates.

Said challenge becomes more complicated when the trim panel has a three-dimensional shape and particularly when the electronic components are provided at the particular areas of the trim part where the shape is more complex comprising a pronounced curved surface.

Patent EP3049227 discloses a method for manufacturing an electromechanical structure comprising a thermoformed film with a three-dimensional shape comprising an electric circuit and electronic components electrically connected to said circuit; and a plastic structural carrier over-molded on the thermoformed film by an injection molding process.

The electrical circuit is printed by a two-dimensional printing process with an electrical conductive ink on the film before being thermoformed.

The printed electric circuit comprises electrical conductive tracks and pads being at the end of the electrical conductive tracks where the electronic components are attached defining in this way the particular positions thereof.

Therefore, said electrical conductive pads are critical areas that define the particular positions of the electronic components due to the fact that said position is related to the corresponding pictogram position with which a particular electronic component cooperates.

In addition, said electrical conductive pads comprising an area very well defined according to the particular features of the electronic component to be mounted on them, such as the size or the power requirements of said electronic component.

This area allows ensuring the electrical connection, the mechanical connection and the thermal dissipation of said particular electronic component in order to ensure a proper operation thereof during its service life.

The electronic components can be attached to the film by surface mounting technology. This step comprises the application of attaching means on the electrical conductive pads and the subsequent assembly of the corresponding electronic component by for example a pick-and-place device.

In order to make easier the attaching step of the electronic components, EP3049227 discloses a method in which in addition to the electric circuit the electronic components are also provided to the film before it is thermoformed, that is, the electronic components are attached to a flat film instead of a film having a complex three-dimensional shape.

For that, the positions where the electronic components are attached on the flat film are previously calculated taking into account the final shape of the three-dimensional film design, said positions are called predefined target positions.

According to EP3049227 said predefined target positions are selected in such a way that they omit substantial deformation during the subsequent thermoforming step wherein the film acquires a three-dimensional shape.

On one hand, the calculation of the predefined target positions taking into account the final three-dimensional shape of the film, is a complicated task involving the use of complex computer programs which, moreover not ensure the definition of the predefined target positions without making complementary physical trials for supplementing the computer program.

On the other hand, once the electronic components are attached to the flat film, it is subjected to two aggressive steps, namely, a thermoforming step in which the film is three-dimensionally formed and an injection molding step in which the film is over-molded for forming the structural carrier.

It implies that the film comprising the electronic components is exposed to thermal and mechanical stress causing the deformation and stretching of the film in such a way that the real positions of the electronic components at the end of the process do not match with the predefined target positions.

On the other hand, the attaching means provided to connect the electronic components to the film are also exposed to thermal and mechanical stress as consequence of said sequential steps, thus they have to be strong enough to stand the stress suffered in order to keep the original attaching position and they have to be flexible enough to stand the deformations suffered in order not to lose their function. It involves the use of special attaching means having particular properties for standing said conditions being a very expensive option.

Likewise, the electronic components are exposed to said thermal and mechanical stress generated during the thermoforming step, so they also have to be chosen to stand said particular conditions. In addition, in this case many electronic components most commonly used are particularly sensitive to the thermal stress.

In addition, the fact that the method omits positions for the electronic components subjected to substantial deformation during the thermoforming step for minimizing the above disclosed problems, limits the design freedom of the final part.

In order to overcome the problems mentioned above, the electronic components can be attached to the film after the film has been thermoformed, that is, on a film having a three dimensional shape.

According to this scenario it is possible to avoid the stress suffered by both, the attachment means and the electronic components due to the fact they are applied on the film after the thermoforming process.

However, a critical part of the electrical circuit, namely the electrical conductive pads defining the particular positions of the electronic components and which have a particular geometry ensuring the proper operation thereof are still subjected to deformation and stretching due to the electrical circuit is printed before the thermoforming step.

On the one hand, this results in a displacement of the position of the pad regarding a predefined target position after the thermoforming step. Thus, when pick-and-place device provides the electronic component on the corresponding pad it will place outside the pad or displaced with respect to its predefined target position.

Even in the case, the pick-and-place device can recalculate the position where the electronic component is attached according to the real displaced position of the electrical pad in order to ensure the electrical connection with each other, this recalculated position is not correct according to the predefined target position. Thus, the relative position between the particular electronic component regarding the pictogram with which it cooperates is not correct. This results in a malfunction of the trim panel.

This problem is aggravated when several pads are located close to each other.

On the other hand, the deformation and stretching of the film during the thermoforming step also modifies the geometry of the area defining the conductive electrical pads. As it has been explained above, said geometry is defined according to the particular features of the electronic component to be mounted on them to ensure the proper operation thereof.

Therefore, the deformation of said geometry can affect the electrical connection, the mechanical connection and/or the thermal dissipation of the electronic component resulting in any malfunction thereof during the service life of the trim panel.

Even in some cases in which the predetermined target position of an electrical conductive pad is in a very pronounced position after the thermoforming process, the pad can be deteriorated to such an extent that the electrical conductivity between the electrical conductive track and said pad can be lost.

In view of the disadvantages mentioned above, the object of the invention is a method for manufacturing a trim panel for vehicles by in-mold electronics technology where the electronic components can be located in areas of the film comprising a pronounced curved surface deformed when the film acquires the three-dimensional shape, and at the same time ensuring both the predefined target position of the electronic component according to the pictogram provided on the decorative covering with which said electronic component cooperates and the proper operation of every electronic component, in order to ensure the correct operation of the trim panel.

### DESCRIPTION OF THE INVENTION

The present invention is defined and characterised by the independent claim, while the dependent claims describe additional features thereof.

Firstly, due to the fact that the method for manufacturing the trim panel is based on in-mold electronics technology the method allows saving cost and time due to the elimination of the assembly process of the different parts forming the trim panel, namely the electrical circuit with the electronic components and the structural carrier and optionally the decorative covering.

Additionally, said technology allows reducing weight and space due to the replacement of rigid electronic components, mainly due to the replacement of the printed circuit board with a thin and flexible plastic film comprising a circuit printed with electrical conductive ink.

In addition to the above, the technology allows increasing the freedom to design regarding the traditional trim panels having an electronic function comprising rigid printed circuit board.

According to the method of the invention the step of printing the electrical circuit is divided into two different steps, namely a first printing step comprising a two-dimensional printing process such as screen-printing, inkjet printing, flexographic, gravure or offset lithographic printing for configuring a first part of the electrical circuit on the first sheet when it comprises a flat shape; and a second printing step comprising a three-dimensional printing process, particularly a fluid dispensing process or a pad printing process for configuring a second part of the electrical circuit on the first sheet when it comprises a three-dimensional shape.

According to the invention the electrical circuit is divided into two different parts, the first part comprising mainly the electrical conductive tracks and the second part comprising the electrical conductive pads being at pronounced curved surfaces of the first sheet.

The first part is the large part of the electrical circuit and it is mainly arranged over flat areas of the first sheet after the forming process, that is, at areas not subjected to significant deformation and stretching during said forming process. It means that it is not complicated to define and it does not require a high definition and precision.

The second part comprises the electrical conductive pads being at complex areas of the first sheet after the forming process. In addition to this, said electrical conductive pads must be accurately defined due to the fact they define the particular positions of the electronic components. The combination of said two conditions results in this part is the most complicated part of the electrical circuit to define.

Regarding the printing process the invention combines two different printed processes, a two-dimensional printing process and a three-dimensional printing process.

The first printing process is a two-dimensional printing process such as screen-printing. This process uses a stencil or a mesh comprising apertures according to a particular design to transfer an ink onto a flat substrate. A squeegee is moved across a screen to fill with ink the apertures of the stencil or mesh to imprint the design on the flat substrate.

This process is mainly characterized for being a fast printing process suitable for printing on flat substrates.

Due to the fact that the large part of the electrical circuit is printed by this two-dimensional printing process, it results in a reduction of the total time cycle needed for configuring the whole electrical circuit.

Due to the fact that said first part of the electrical circuit does not need a high definition and precision, the stencils or meshes used during this first printing process can be simplified resulting in a reduction of the cost of the process.

Additionally, due to the fact that said first part does not need a high definition and precision, the number of the rejected parts not fulfilling definition requirements can be reduced as well.

The second printing process is a fluid dispensing process or a pad printing process.

Fluid dispensing process is a three-dimensional printing process using an automated fluid dispenser fixed to a robot or automaton to dispense an ink on a substrate having any kind of shape.

Pad printing process is a printing process used for transferring two dimensional images onto three dimensional objects. It uses a silicon pad for taking a two dimensional image from an engraved printing plate, also called cliché which transfers the image to a three dimensional substrate.

Both processed are mainly characterized for accurately dispensing the ink according to a high degree of precision regardless of the degree of shape complexity of the substrate to be printed.

Due to the fact that the electrical conductive pads being at complex areas of the first sheet of the electrical circuit are printed by this three-dimensional printing process and after the forming step, said electrical conductive pads can be accurately defined regardless of the complex shape of the first sheet and said accurately definition remains at the end of the process.

On one hand it means that the electrical conductive pad once it is configured, is not deformed due to the forming process in such a way that its final position does not divert with respect to the predefined target position. This contributes to the proper operation of the whole trim panel.

In addition, since the electrical conductive pad is not deformed and stretched, the particular geometry of the electrical conductive pad remains intact to fulfil the technical requirements of the particular electronic component to be mounted on it. This contributes to the proper operation of the particular electronic component. Additionally, the use of special conductive inks having thermoformable properties for configuring the electrical conductive pads are not necessary since that they are printed after the forming process. It allows using common electrical conductive inks being a cheaper option.

On the other hand, particularly both the fluid dispensing process and the pad printing process by themselves allow precisely dispensing a controlled quantity of the second conductive ink at the predefined target area in order to define the electrical conductive pad regardless of the complex shape of the area where it is dispensed.

Regarding the attaching step of the first electronic component, it is also carried out after the forming step.

This results in that both, the electronic component and the attaching means connecting the electronic component to the first sheet are not exposed to the stress generated during the forming process.

Therefore, the attaching means do not require special properties such as elasticity to stand the stretching and deformation produced during said forming process.

In addition, due to the fact that the attaching means are not weakening during the forming process, they are able to better stand the injecting process conditions.

On the other hand, as the electronic component are not exposed to the stress produced during the forming process, the possibility they are deteriorate is also reduced.

Thus, it is not necessary that either the attaching means or the electronic components have special properties to stand said critical process conditions which allows using common components resulting in a cheaper option.

Additionally, upon the forming process finishing it may happen that the first sheet comprising the three-dimensional shape has any quality problem as a result of this forming process that implies the rejection of the first sheet.

According to this scenario, given that the electronic component has not yet attached to the first sheet and consequently it does not form part of it, the cost of the resulting scrap is cheaper than in the case it forms part thereof.

Additionally, splitting the printing process into two steps allows to rectify potential errors produced in the first part of the electrical circuit as consequence of the deformation and stretching of the first sheet during the forming process that might cause a loss of the electrical continuity along the electrical conductive track. In these cases, the fluid dispensing process or the pad printing process would allow rectifying said errors.

Thus, the number of rejected parts can be further reduced.

### DESCRIPTION OF THE DRAWINGS

The present specification is complemented by a set of figures that illustrate a preferred embodiment, in no way limiting the invention.
Figures 1 to 16 show a schematic view of the method for manufacturing trim panels for vehicles having an electronic function according to the invention through the components obtained in each step. Particularly, figures 1, 3, 5, 7, 9, 11, 13 and 15 show a top view of the said components and figures 2, 4, 6, 8, 10, 12, 14 and 16 show the corresponding cross-sectional view thereof.
Figures 13 and 14 particularly show a top view and a cross-sectional view respectively according to a first embodiment of the invention in which the electronic component is not perpendicularly aligned with its corresponding pictogram.
Figures 15 and 16 particularly show a top view and a cross-sectional view respectively according to a second embodiment of the invention in which the electronic component is perpendicularly aligned with its corresponding pictogram.
Figure 17 shows a top view of the first sheet after step d) wherein the detail I corresponding to an electrical pad is surrounded.
Figure 18 shows a schematic enlarged view of the detail I represented in the figure 17.
Figure 19 shows a top view of the first sheet after step i) wherein a light management material affecting the light emitted by the lighting device is schematically represented.
Figure 20 shows a cross-sectional view of the trim panel according to an embodiment of the invention in which the shape of the decorative covering matches with the shape of the shape of the first sheet.
Figure 21 shows a schematic enlarged view of the detail J represented in the figure 20 according to a first embodiment.
Figure 22 shows a schematic enlarged view of the detail J represented in the figure 20 according to a second embodiment.
Figure 23 shows a cross-sectional view of the trim panel according to an embodiment of the invention in which the shape of the decorative covering partially matches with the shape of the shape of the first sheet.
Figure 24 shows a perspective view of a trim panel according to the invention where some particular pictograms are represented.

### DETAILED DESCRIPTION OF THE INVENTION

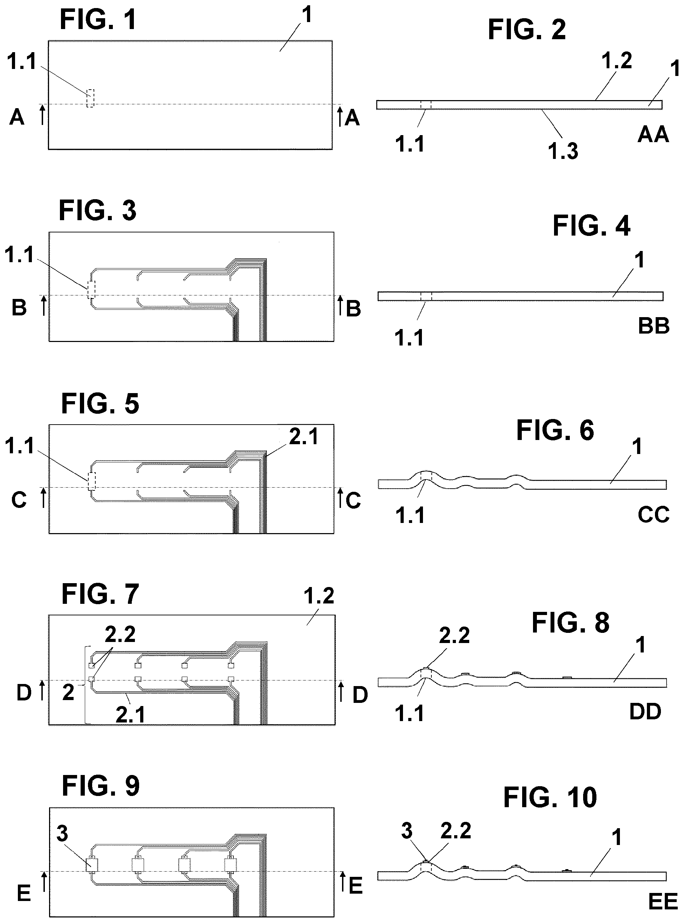

Figures 1 to 16 show a schematic view of the method for manufacturing trim panels (10) for vehicles having an electronic function through the components obtained in each step.

The method starts with the step a) represented in figures 1 and 2. In this step a) it is provided a first sheet (1) comprising a flexible flat plastic film having a first area (1.1) being flat.

The plastic film includes a material selected from the group of polycarbonate (PC), Polymethyl methacrylate (PMMA), polyester (PE), polyethylene terephthalate (PET), polypropylene (PP), thermoplastic polyurethane (TPU).

The plastic film preferably comprises a thickness being between 50-750 µm.

The method continues with the step b) represented in figures 3 and 4. In this step b) the first sheet (1) being flat, is printed with a first electrical conductive ink (6) for forming an electrical conductive track (2.1) at its first side (1.2).

Said electrical conductive track (2.1) printed during this step forms the first part of the electrical circuit (2).

In addition of the electrical conductive track (2.1), other parts forming the electrical circuit (2) can be printed during this step b), particularly other parts remaining at substantially flat areas of the first sheet (1) after the forming process of step c). Thus, said optional electrical parts, also form the first part of the electrical circuit (2).

The printing process of step b) comprises a two-dimensional printing process such as screen-printing, inkjet printing, flexographic, gravure or offset lithographic printing.

The first conductive ink (6) is specifically formulated in terms of materials and viscosity to favour both its compatibility with the first sheet (1) and to be applied by the two dimensional printing process.

It can comprise a dispersion of particles comprising a conductive metal, dispersed in a solvent. Said conductive metal can for example be silver, copper, a combination thereof, etc.

The dynamic viscosity of the first conductive ink (6) can vary in the range between 5,000 and 200,000 mPas at room temperature, being between 20 and 22 °C.

After step b), the method continues with the step c) represented in figures 5 and 6. In this step c) the first sheet (1) comprising the electrical conductive track (2.1), and optionally other parts forming the electrical circuit (2), is formed according to a three-dimensional shape in such a way that the first area (1.1) has a three-dimensional shape as figure 6 shows.

It means that the first area (1.1) is deformed and stretched during the forming step for adopting a three-dimensional shape. Said forming process can be carry out for example by thermoforming or by cold forming.

Then, the method continues with step d) represented in figures 7 and 8. In this step d) an electrical conductive pad (2.2) configured to be connected to the electrical conductive track (2.1) is printed with a second conductive ink (7) on the first area (1.1) previously deformed, particularly on the first side (1.2) of the first sheet (1).

The printing process of step d) comprises a three-dimensional printing process, particularly, a fluid dispensing process or a pad printing process.

In case of fluid dispensing process, it can use an automated fluid dispenser fixed to a robot or automaton to dispense the second conductive ink (7) on the first sheet (1), and particularly on the first side (1.2) thereof.

Some examples of fluid dispensing technologies can be piezo jet valve dispensing, aerosol jet printing, 3D dispensing or pneumatic Spray.

In case of pad printing process, it can use a silicon pad for taking the second conductive ink (7) from an engraved printing plate called cliché, in order to transfer said second conductive ink (7) on the first sheet (1), and particularly on the first side (1.2) thereof.

The second conductive ink (7) is specifically formulated in terms of materials and viscosity to favour both its compatibility with the first sheet (1) and to be applied by the three dimensional printing process.

It can comprise a dispersion of particles comprising a conductive metal, dispersed in a solvent. Said conductive metal can for example be silver, copper, a combination thereof, etc.

Depending on the particular fluid dispensing technology or the pad printing process, the dynamic viscosity of the second ink can vary in the range between 1 and 1,000,000 mPas at a room temperature, being between 20 and 22 °C.

For example, in case of piezo jet valve dispensing the dynamic viscosity is in the range between 50-200,000 mPas, in the case of aerosol jet printing the dynamic viscosity is in the range between 1-20 mPas, in the case of 3D dispensing the dynamic viscosity in the range between 1-1,000,000 mPas, in the case of pneumatic Spray the dynamic viscosity is in the range between 600-150,000 mPas, in the case of pad printing is in the range between 80-1,000 mPas.

According to a particular case, the first conductive ink (6) and the second conductive ink (7) are the same conductive ink. This results particularly advantageous since a single conductive ink is managed during the entire process.

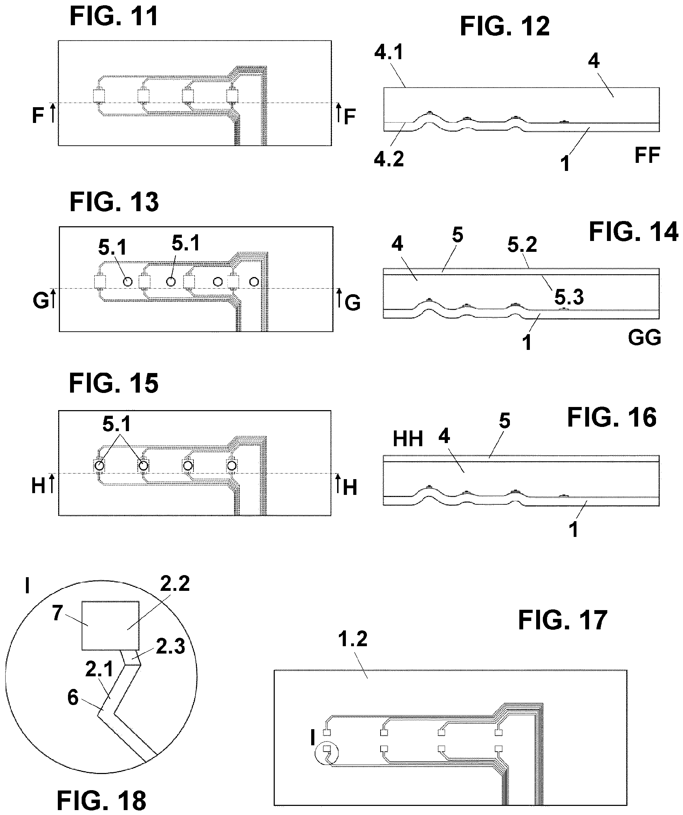

The electrical conductive pad (2.2) can be directly connected to the electrical conductive track (2.1) in order to ensure the electrical continuity between both parts or it can be indirectly connected through an electrical intermediate portion (2.3) as it is represented in figure 18.

The electrical intermediate portion (2.3), if necessary, is printed by fluid dispensing or by pad printing during the step d).

Said electrical intermediate portion (2.3) can be convenient for example in case the path of the end of an electrical conductive track (2.1) diverts from the path originally defined as consequence of the stretching of the first sheet (1) suffered during the forming process as the detail of figure 18 shows.

In such case, the electrical conductive pad (2.2) printed according to a predefined target position, that is, the position being in correspondence with the corresponding pictogram (5.1) in the final trim part (10), is not connected to the electrical conductive track (2.1).

Therefore, the electrical intermediate portion (2.3) is printed to connect both parts (2.1, 2.2) and in this way ensuring the electrical continuity between them without modifying the position of the electrical conductive pad (2.2) according to the predefined target position thereof.

In addition, said electrical intermediate portion (2.3) can be convenient in case in which several electrical conductive pads (2.2) are very closed together.

In such a case, the corresponding electrical conductive tracks (2.1) are defined according to a shorter length than the necessary to connect each one with the corresponding electrical conductive pad (2.2). This is to avoid connection errors between an electrical conductive track (2.1) and a non-corresponding electrical conductive pad (2.2) which is very closed to the corresponding electrical conductive pad (2.2).

Thus, the electrical intermediate portion (2.3) would allow connecting said shorter electrical conductive track (2.1) with the corresponding electrical conductive pad (2.2) minimizing the risk of short circuit.

Optionally, the present invention also considers that said step d) can be used to print other portions of the electrical circuit such as an electrical conductive track (2.1) partly or completely, which are extended over a very deformed area of the first sheet (1) in order to ensure the integrity of said portions due to the fact that said portions are not subjected to the forming process of step c).

Additionally, this step d) can be used to correct errors produced in the first part of the electrical circuit (2) previously configured in the first printing step b) as a result of the stretching of the first sheet (1) during the forming step c).

Next step in the method comprises step e) represented in figures 9 and 10. In this step e) an electronic component (3) is attached to the corresponding electrical conductive pad (2.2). Thus, the electronic component (3) can be powered by said electrical conductive pad (2.2).

For this attaching step, for example a pick-and-place device can be used. It comprises a robot used to place surface-mount devices (SMDs) onto a printed circuit. Said devices are characterized for high speed and high precision placing of a broad range of electronic components.

The electronic component (3) can be for example a lighting device such as a LED, a sensor, a resistor, a capacitor, an inductor, an antenna or a micro-controller.

Preferably, the first sheet (1) comprises several of them combined.

Regarding the attaching means, that is, the means responsible for ensuring the electronic component (3) attachment to the corresponding electrical conductive pad (2.2) during the following steps of the method, the invention considers several options.

One possible option is to attach the electronic component (3) directly to the electrical conductive pad (2.2). In this case, the electronic component (3) is attached to the electrical conductive pad (2.2) before the second electrical conductive ink (7) is cured in such a way that said second electrical conductive ink (7) additionally acts as an adhesive. Once it is cured, the attachment between both components (2.2, 3) is consolidated.

In order to improve the mechanical connection between both components (2.2, 3), a structural adhesive (9) can be deposited on the electronic component (3) after attaching it to the electrical conductive pad (2.2).

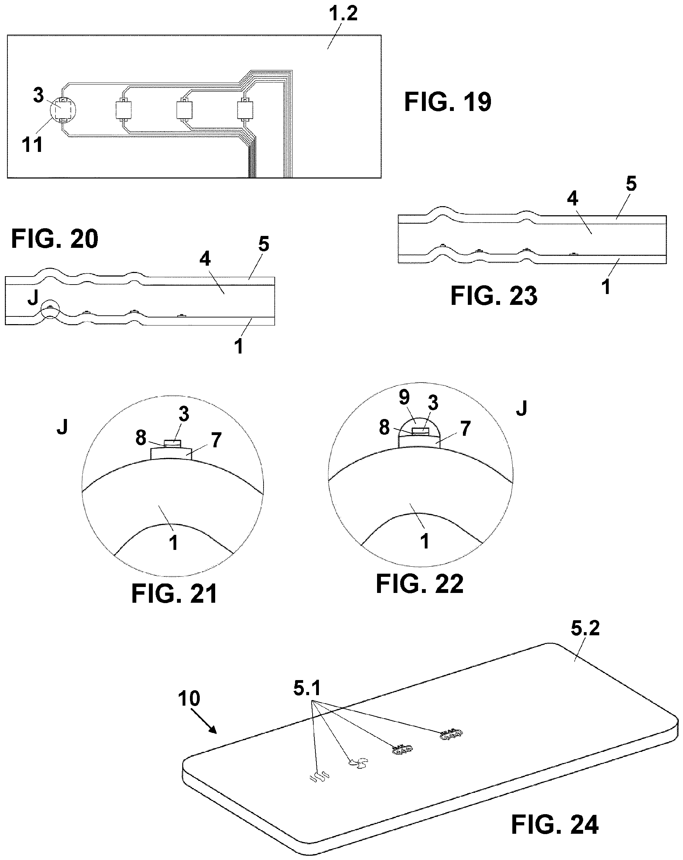

Other possible option shown in figure 21, is to attach the electronic component (3) by depositing a third electronic conductive ink (8) on the electrical conductive pad (2.2) once it is cured. Said third electrical conductive ink (8) allows electrically and mechanically connecting the electronic component (3) to the electrical conductive pad (2.2).

In order to improve the mechanical connection between both components (2.2, 3) according to this option, said third electrical conductive ink (8) can be structural.

Other option to improve the mechanical connection between both components (2.2, 3) shown in figure 22, is to deposit a structural adhesive (9) after attaching the electronic component (3) to the electrical conductive pad (2.2) by the third electronic conductive ink (8). This structural adhesive (9) at least is deposited around to the periphery of the electronic component (3), namely on its connection pinouts in order not to affect the electronic component (3) operation.

Structural term mentioned above for defining the structural adhesive (9) and to the third electrical conductive ink (8), means that said materials comprise particular mechanical properties to stand the mechanical and thermal stress produced during the subsequent injection process of step f).

Third electrical conductive ink (8) and/or structural adhesive (9) can be applied by fluid dispensing or pad printing processes.

In a case in which the electronic device (3) is particularly a lighting device such as a LED the method optionally can further comprise a step i) after the step e) comprising a step of printing a light management material (11) on said lighting device affecting the light emitted by said lighting device, as figure 19 shows.

Said light management material (11) can act as a collimator, a diffusor, or other optical component depending on the particular optical properties to be achieved.

In the Step f) represented in figures 11 and 12, a plastic material is injected on the first sheet (1), and particularly on its first side (1.2), in order to form a carrier sheet (4) covering the first electronic component (3) .

Optionally, if the step g) is carried out before step f), the plastic material is injected between both, the first sheet (1) and the decorative covering (5) below described.

Said carrier sheet (4) can be totally or partially extended on the first side (1.2) of the first sheet (1), and optionally the decorative covering (5).

Thus, the carrier sheet (4) comprises a second side (4.2) facing the first side (1.2) of the first sheet (1) and a first side (4.1) opposite to said first side (4.1) .

The main function of this carrier sheet (4) is to provide structural support to the trim panel (10).

The plastic material forming this carrier sheet (4) can be for example thermoplastic such as polycarbonate (PC), polymethyl methacrylate (PMMA), polypropylene (PP) or polyamide (PA), polyethylene terephthalate (PET), or thermosetting such as polyurethane (PU).

In this step f), the first sheet (1) having a three-dimensional shape and comprising the electrical circuit (2) and the electronic components (3) is introduced inside an injection mold and then the plastic material is injected against said first sheet (1) embedding at least partially both, the electrical circuit (2) and the electronic components (3).

According to an embodiment of the invention in which the electronic device (3) is particularly a lighting device such as a LED, the plastic material can be a light transmitting material which can be transparent or translucent. In case of being translucent, it can comprise light diffusing additives.

The carrier sheet (4) can be totally or partly formed by light transmitting material. In case of being partly formed, said light transmitting material is extended only at the portion or portions of the carrier sheet (4) affected by the light emitted by the lighting device. In this last case the carrier sheet (4) comprises both, light transmitting material and opaque material.

Thus, the carrier sheet (4) or part of the carrier sheet (4) acts as a light guide for distributing and transmitting the light emitted by the lighting device towards the first side (4.2).

Finally, the process comprises the step g) represented in figures 13 and 14 according to a first option and in figures 15 and 16 according to a second option. In this step g) a decorative covering (5) is provided. This decorative covering (5) is configured to be at the first side (4.2) of the carrier sheet (4).

Thus, the decorative covering (5) comprises a second side (5.3) facing the first side (4.1) of the carrier sheet (4) and a first side (5.2) opposite to the second side (5.3) configuring the visible side of the trim panel (10).

The decorative covering (5) can comprise a plastic film as the first sheet (1), a wood veneer sheet, a leather sheet, a textile, a metal sheet, a stone sheet, a cork sheet, or any other sheet usually used as decorative covering in a vehicle.

In the particular case of being a plastic film as the first sheet (1) is, the decorative covering (5) can be manufactured according to the steps a) to e) or according to the steps a) to c).

Thus, the decorative covering (5) can be formed according to a three-dimensional shape and can comprise and electrical circuit (2) and additionally electronic components (3).

In case the decorative covering (5) is formed according to a three-dimensional shape, said shape can totally match with the shape of the first sheet (1) as figure 20 shows or can partly match with the shape of the first sheet (1) as figure 23 shows.

The invention also considers an option in which the decorative covering (5) shape does not match with the shape of the first sheet (1) as figures 14 and 16 show.

According to an embodiment of the invention, the decorative covering (5) can be inserted inside the injection mold as the first sheet (1) in order the plastic material is injected between them for forming the trim part (10), that is, step g) is carried out before the injection molding step f).

According to other embodiment of the invention, the decorative covering (5) can be attached to the assembly formed by the first sheet (1) and the carrier sheet (5) after the injection molding step f), that is outside the injection mold by a laminating process for example.

The decorative covering (5) can also comprise a coating directly applied on the carrier sheet (4).

The decorative covering (5) can further comprise a laminate. For example, it can comprise a light transmitting layer comprising a decorative effect, a mask layer provided at one side of the light transmitting layer and a protective layer or coating at the other side of the light transmitting layer, particularly at the visible side of the trim panel (10).

Preferably, the decorative covering (5) is partly opaque in order to conceal all the components being inside the trim panel (10).

The decorative covering (5) has at least a pictogram (5.1) configured for cooperating with the electronic component (3) of the first sheet (1).

As it is mentioned above, the term "cooperation" in the context of the invention means that the electronic component (3) and the corresponding pictogram (5.1) work together for a common purpose.

In case the electronic component (3) is a lighting device, the light emitted by said lighting device is transmitted to the outside of the trim panel (10) through the corresponding pictogram (5.1), so the common purpose is to emit light towards the outside of the trim panel (10) .

In case the electronic component (3) is a sensing antenna for a proximity switch, the signal sensed by the sensing antenna is detected through the pictogram (5.1), for example due to the fact that the vehicle occupant's finger get closes or touches the pictogram (5.1). So the common purpose is to activate a proximity switch.

The pictogram (5.1) can be any figurative or symbolic drawing used for communication purposes and/or decorative purposes, which the vehicle occupant can identify as figure 24 shows.

The pictogram (5.1) can be a light transmitting portion being backlighted in order to make easier its identification and in order to provide additional information by changing the colour and/or the intensity of the light according to the particular circumstance.

Said pictogram (5.1) can also be an opaque portion representing a distinguishing portion in the decorative covering (5) due to a change of color, a change of relief or both.

The pictogram (5.1) can be configured by printing on the covering layer (5) or on any layer forming the covering layer (5). It also can be configured by laser cutting an opaque layer acting as a mask.

In the embodiment represented in the figures 13 and 14, the electronic component (3) comprises a lighting device such as a LED. The corresponding pictogram (5.1) with which the lighting device cooperates is light transmitting.

As figure 13 shows, the lighting device is convenient located according to a non-aligned position with the corresponding pictogram (5.1) regarding a main axis perpendicular to the lighting device extended through the thickness of the trim panel (10).

Said non-aligned position is particularly selected to fulfil a double function, to avoid undesirable hot spots due to the lighting device is too close to the corresponding pictogram (5.1) and to ensure that the light provided through the corresponding pictogram (5.1) meets the requirements in terms of light intensity.

In the embodiment represented in the figures 15 and 16, the electronic component (3) comprises a sensing antenna for a proximity switch. The corresponding pictogram (5.1) with which said sensing antenna cooperates can be light transmitting or a distinguished opaque portion by a vehicle user.

As figure 15 shows, the sensing antenna is convenient located according to an aligned position with the corresponding pictogram (5.1) regarding a main axis perpendicular to the sensing antenna extended through the thickness of the trim panel (10) in such a way that sensitivity of the antenna is not penalized.

The invention also considers other embodiment in which a particular pictogram (5.1) cooperates at the same time with two electronic components (3) such as a sensing antenna and a lighting device. This case makes easier the identification of the pictogram (5.1) for switching some function due to the fact that it is backlighted.

In addition, the invention also considers other embodiment in which a particular pictogram (5.1) cooperates at the same time with more than one lighting device. This case may be convenient depending on the intensity necessities or the size of the pictogram (5.1) to be backlighted.

The trim panel (10) of the invention can be any trim panel having an aesthetic function and covering any interior or exterior bodywork part of the vehicle.

In case the trim panel (10) covers an internal bodywork part of the vehicle it can be for example a door trim, a pillar trim, a dashboard trim, a central console trim, a floor carpet, a roof trim, a sunvisor, or a portion of any of them. Other interior trim panels can be considered by the invention.
In case the trim panel (10) covers an exterior bodywork part of the vehicle it can be for example a door exterior trim, a pillar exterior trim, an exterior emblem trim, a radiator grille trim or a portion of any of them. Other exterior trim panels can be considered by the invention.

## Claims

1. Method for manufacturing trim panels (10) for vehicles having an electronic function comprising the following steps:
a) providing a first sheet (1) comprising a flexible flat plastic film having a first area (1.1) being flat,
b) printing an electrical conductive track (2.1) on the first sheet (1) with a first electrical conductive material (6) by screen-printing, inkjet printing, flexographic, gravure or offset lithographic printing,
c) forming the first sheet (1) comprising the electrical conductive track (2.1) according to a three-dimensional shape in such a way that the first area (1.1) has a three-dimensional shape,
d) printing an electrical conductive pad (2.2) connected to the electrical conductive track (2.1) on the first area (1.1) with a second electrical conductive ink (7) by fluid dispensing or pad printing,
e) attaching an electronic component (3) to the electrical conductive pad (2.2) in order to said electronic component (3) can be electrically powered by said electrical conductive pad (2.2),
f) injecting a plastic material on the first sheet (1) forming a carrier sheet (4) covering the electronic component (3), wherein the carrier sheet (4) comprises a second side (4.2) facing the first sheet (1) and a first side (4.1) opposite to the second side (4.2),
g) providing a decorative covering (5) configured to be at the first side (4.1) of the carrier sheet (4) comprising a pictogram (5.1) configured for cooperating with the electronic component (3).

2. Method for manufacturing trim panels (10) for vehicles having an electronic function according to claim 1 wherein in step d) an intermediate portion (2.3) connecting the electrical conductive track (2.1) and the electrical conductive pad (2.2) is also printed with the second electrical conductive ink (7) by fluid dispensing or pad printing.

3. Method for manufacturing trim panels (10) for vehicles having an electronic function according to claim 1 wherein the decorative covering (5) comprises a plastic film manufactured according to the steps a) to e).

4. Method for manufacturing trim panels (10) for vehicles having an electronic function according to claim 1 wherein the electronic component (3) is directly attached to the electrical conductive pad (2.2).

5. Method for manufacturing trim panels (10) for vehicles having an electronic function according to claim 1 wherein the step e) further comprises printing a third electrical conductive ink (8) on the electrical conductive pad (2.2) configured to attach the electronic component (3) to said electrical conductive pad (2.2).

6. Method for manufacturing trim panels (10) for vehicles having an electronic function according to claim 5 wherein the third conductive ink (8) is structural.

7. Method for manufacturing trim panels (10) for vehicles having an electronic function according to any claims 1 or 5 wherein after step e) a structural adhesive (9) is dispensed on the electronic component (3).

8. Method for manufacturing trim panels (10) for vehicles having an electronic function according to claim 1 wherein the electronic component (3) is a lighting device.

9. Method for manufacturing trim panels (10) for vehicles having an electronic function according to claim 8 wherein the plastic material is light transmitting and the carrier sheet (4) is a light guide configured to distribute and to transmit the light emitted by the lighting device towards the first side (4.1) of the carrier sheet (4).

10. Method for manufacturing trim panels (10) for vehicles having an electronic function according to claim 9 wherein the light transmitted by the light guide passes through the pictogram (5.1) in order to be visible outside the trim panel (10).

11. Method for manufacturing trim panels (10) for vehicles having an electronic function according to claim 10 wherein the lighting device is located according to a non-aligned position with the corresponding pictogram (5.1) regarding a main axis perpendicular to the lighting device extended through the thickness of the trim panel (10) .

12. Method for manufacturing trim panels (10) for vehicles having an electronic function according to claim 1 wherein the electronic component is an antenna for a proximity switch located according to an aligned position with the corresponding pictogram (5.1) regarding a main axis perpendicular to the antenna extended through the thickness of the trim panel (10).

13. Method for manufacturing trim panels (10) for vehicles having an electronic function according to claim 8 wherein the method further comprises a step i) after the step e), said step i) comprising a step of printing a light management material on the lighting device affecting the light emitted by said lighting device.

## Amended claims

### Amended claims in accordance with Rule 137(2) EPC.

1. Method for manufacturing trim panels (10) for vehicles having an electronic function comprising the following steps:
a) providing a first sheet (1) comprising a flexible flat plastic film having a first area (1.1) being flat,
b) printing an electrical conductive track (2.1) on the first sheet (1) with a first electrical conductive material (6) by screen-printing, inkjet printing, flexographic, gravure or offset lithographic printing,
c) forming the first sheet (1) comprising the electrical conductive track (2.1) according to a three-dimensional shape in such a way that the first area (1.1) has a three-dimensional shape,
d) printing an electrical conductive pad (2.2) connected to the electrical conductive track (2.1) on the first area (1.1) with a second electrical conductive ink (7) by fluid dispensing or pad printing,
e) attaching an electronic component (3) to the electrical conductive pad (2.2) in order to said electronic component (3) can be electrically powered by said electrical conductive pad (2.2),
f) injecting a plastic material on the first sheet (1) forming a carrier sheet (4) covering the electronic component (3), wherein the carrier sheet (4) comprises a second side (4.2) facing the first sheet (1) and a first side (4.1) opposite to the second side (4.2),
g) providing a decorative covering (5) configured to be at the first side (4.1) of the carrier sheet (4) comprising a pictogram (5.1) configured for cooperating with the electronic component (3).

2. Method for manufacturing trim panels (10) for vehicles having an electronic function according to claim 1 wherein in step d) an intermediate portion (2.3) connecting the electrical conductive track (2.1) and the electrical conductive pad (2.2) is also printed with the second electrical conductive ink (7) by fluid dispensing or pad printing.

3. Method for manufacturing trim panels (10) for vehicles having an electronic function according to claim 1 wherein the decorative covering (5) comprises a plastic film, and said decorative covering is manufactured according to the steps a) to e).

4. Method for manufacturing trim panels (10) for vehicles having an electronic function according to claim 1 wherein the electronic component (3) is directly attached to the electrical conductive pad (2.2).

5. Method for manufacturing trim panels (10) for vehicles having an electronic function according to claim 1 wherein the step e) further comprises printing a third electrical conductive ink (8) on the electrical conductive pad (2.2) configured to attach the electronic component (3) to said electrical conductive pad (2.2).

6. Method for manufacturing trim panels (10) for vehicles having an electronic function according to claim 5 wherein the third conductive ink (8) is structural that is, said third conductive ink (8) comprises particular mechanical properties to stand the mechanical and thermal stress produced during the subsequent injection process of step f).

7. Method for manufacturing trim panels (10) for vehicles having an electronic function according to any claims 1 or 5 wherein after step e) a structural adhesive (9) is dispensed on the electronic component (3), and wherein said structural adhesive (9) comprises particular mechanical properties to stand the mechanical and thermal stress produced during the subsequent injection process of step f).

8. Method for manufacturing trim panels (10) for vehicles having an electronic function according to claim 1 wherein the electronic component (3) is a lighting device.

9. Method for manufacturing trim panels (10) for vehicles having an electronic function according to claim 8 wherein the plastic material is light transmitting and the carrier sheet (4) is a light guide configured to distribute and to transmit the light emitted by the lighting device towards the first side (4.1) of the carrier sheet (4).

10. Method for manufacturing trim panels (10) for vehicles having an electronic function according to claim 9 wherein the light transmitted by the light guide passes through the pictogram (5.1) in order to be visible outside the trim panel (10).

11. Method for manufacturing trim panels (10) for vehicles having an electronic function according to claim 10 wherein the lighting device is located according to a non-aligned position with the corresponding pictogram (5.1) regarding a main axis perpendicular to the lighting device extended through the thickness of the trim panel (10).

12. Method for manufacturing trim panels (10) for vehicles having an electronic function according to claim 1 wherein the electronic component is an antenna for a proximity switch located according to an aligned position with the corresponding pictogram (5.1) regarding a main axis perpendicular to the antenna extended through the thickness of the trim panel (10).

13. Method for manufacturing trim panels (10) for vehicles having an electronic function according to claim 8 wherein the method further comprises a step i) after the step e), said step i) comprising a step of printing a light management material on the lighting device affecting the light emitted by said lighting device.
